# EUROPEAN PATENT SPECIFICATION

(11) **EP 2 682 983 B1**
(45) Date of publication and mention of the grant of the patent: **31.08.2016**
(21) Application number: 12174733.1
(22) Date of filing: 03.07.2012
(51) Int. Cl.: H01L 21/8238, H01L 21/84, H01L 27/12, H01L 27/092

(54) **CMOS device comprising silicon and germanium and method for manufacturing thereof**
CMOS-Vorrichtung mit Silizium und Germanium und Herstellungsverfahren dafür
Dispositif CMOS comprenant du silicium et germanium et son procédé de fabrication

(43) Date of publication of application: 08.01.2014
(73) Proprietor: IMEC, 3001 Leuven (BE)
(72) Inventor: Mitard, Jerome, 3001 Leuven (BE); Witters, Liesbeth, 3001 Leuven (BE)
(74) Representative: Office Kirkpatrick

(56) References cited:
- WO-A1-2006/060054
- WO-A2-03/105204
- US-A1- 2005 136 584
- US-A1- 2005 158 934
- US-A1- 2006 033 095
- US-A1- 2008 006 908
- US-A1- 2012 091 528
- US-A1- 2012 104 472
- DATABASE INSPEC [Online] THE INSTITUTION OF ELECTRICAL ENGINEERS, STEVENAGE, GB; 4 June 2012 (2012-06-04), LE ROYER C ET AL: "High Performance FDSOI MOSFETs and TFETs Using SiGe Channels and Raised Source and Drain", XP002687888, Database accession no. 12822870 -& C LE ROYER ET AL: "High Performance FDSOI MOSFETs and TFETs Using SiGe Channels and Raised Source and Drain", 2012 INTERNATIONAL SILICON-GERMANIUM TECHNOLOGY AND DEVICE MEETING 4-6 JUNE 2012 BERKELEY, CA, USA, 4 June 2012 (2012-06-04), - 6 June 2012 (2012-06-06), page 2 pp., XP002687889, 2012 International Silicon-Germanium Technology and Device Meeting IEEE Piscataway, NJ, USA DOI: 10.1109/ISTDM.2012.6222480 ISBN: 978-1-4577-1864-9

## Description

### Technical field

The present disclosure relates to the field of CMOS devices comprising silicon and germanium and methods of manufacturing thereof. In certain aspects it relates more specifically to the field of FINFET devices.

### Background art

In US2004178406A1 a strained crystalline layer having a tensilely strained SiGe portion and a compressively strained SiGe portion is disclosed in the context of CMOS microelectronic devices.

The strained crystalline layer is epitaxially bonded, or grown, on top of a SiGe relaxed buffer layer, in a way that the tensilely strained SiGe has a Ge concentration below that of the SiGe relaxed buffer, and the compressively strained SiGe has a Ge concentration above that of the SiGe relaxed buffer. The strained crystalline layer and the relaxed buffer can reside on top a semi-insulator substrate or on top of an insulating divider layer. In some embodiments the tensile SiGe layer is pure Si, and the compressive SiGe layer is pure Ge. The tensilely strained SiGe layer is suited for hosting electron conduction type devices and the compressively strained SiGe is suited for hosting hole conduction type devices. Implanted source/drain structures are disclosed. The use of implanted source/drain structures is expected not to work at the advanced node scale (i.e. having gate lengths below 30 nm), because for such reduced gate lengths, dopants are needed to counteract short channel effects, which results in stress relaxation and performance loss (drive current, instability of electrical parameters as for instance variability effect).

The documents US2006/0033095, US2011/0180847, US2011/0175166 and US2009/0065853 disclose strained SiGe FinFET transistors. The document US2005/0136584 and the article "High Performance FDSOI MOSFETs and TFETs Using SiGe Channels and Raised Source and Drain" by C. Le Royer, ISBN 978-1-4577-1864-9, Silicon-Germanium Technology and Device Meeting (ISTDM), 2012 International, - 20120604 - IEEE, pages 1 - 2, disclose planar CMOS FETs with strained SiGe channels. 25

### Summary of the disclosure

It is an aim of the present disclosure to provide CMOS devices comprising silicon and germanium and methods for manufacturing thereof, which can effectively be produced and applied at the advanced node scale. Moreover it is an aim of the present disclosure to provide non-planar CMOS devices, preferably of the FET type, for instance of the FINFET type or 3D gate type, and associated methods.

This aim is achieved according to the disclosure with a CMOS device showing the technical characteristics of the first independent claim.

It is another aim of the present disclosure to provide a method according to the second independent claim.

According to a first aspect of the present disclosure, a CMOS device, preferably a CMOS FET device, comprising silicon and germanium is described, comprising
- a substrate;
- a buffer layer on the substrate, the buffer layer comprising Si₁₋ₓ,Geₓ;
- a local nMOS channel layer element of a first FET device, e.g. a FINFET device, on the buffer layer (Si_{1-z},Ge_{z} with z<x); and
- a local pMOS channel layer element of a second FET device, e.g. a FINFET device, on the buffer layer (Si_{1-y},Ge_{y} with y>x);
wherein x < 0.50 and wherein the nMOS channel layer element and the pMOS channel layer element extend from a surface defined by a common upper surface of the buffer layer.

The substrate can be for instance but not only a silicon substrate, a SOI (Silicon On Insulator) substrate, a strained SOI (sSOI) substrate, or a SiGe bulk substrate (fully relaxed), a III-V based substrate.

A "channel layer element" refers to a portion of a channel layer. Typically, a series of nMOS channel layer elements and a series of pMOS channel layer elements can be provided on a substrate in a manner arranged as known to the skilled person. The channel layer elements can for instance be rectangular, rectangular with rounded corners, elliptical, or can have any other shape known as suitable for the skilled person, when looked upon from above in a direction essentially perpendicular on a front main surface of the substrate. The channel layer elements can comprise an upper surface which can for instance be rectangular, rectangular with rounded corners, elliptical, or can have any other shape known as suitable for the skilled person. They can comprise a similar shaped lower surface. They can have an upper and a lower surface which are essentially of the same shape. The channel layer elements can constitute a fin or 3D-gate structure of respective FET structures. The channel layer elements preferably extend from an essentially planar surface defined by the upper surface of the buffer layer. The channel layer elements preferably comprise side surfaces which connect their respective upper surfaces with their respective lower or bottom surface. The side surfaces may be essentially perpendicular on a front surface of the substrate.

The channel layer element of all pMOS devices, or of all nMOS devices, can be formed at the same time and can comprise a similar composition.

This type of devices can advantageously be produced by the method according to the second aspect of the present invention, and exhibits improved performance.

According to preferred embodiments, x is within the range of 0.15 to 0.45, or within the range of 0.15 to 0.35, for instance about 0.25.

This range is advantageous as it allows the formation of compressive stress in the pMOS channel layer elements and/or the formation of tensile stress in the nMOS channel layer element, which are both provided on top of the buffer layer, by providing a higher Ge concentration for the pMOS channel layer element than for the SiGe buffer layer and/or by providing a lower Ge concentration in the nMOS channel layer element than for the SiGe buffer layer, while still allowing an efficient cleaning of the pMOS and/or nMOS channel layer, which may for instance be needed before providing a gate structure (or a removable gate structure), or before providing elevated source and drain electrodes on the pMOS and/or nMOS channel layer.
The introduction of a certain amount of compressive stress in the pMOS channel layer element at least partially controls the mobility or/and velocity of p-type charge carriers in the pMOS channel layer element.
The introduction of a certain amount of tensile stress in the nMOS channel layer element at least partially controls the mobility or/and velocity of n-type charge carriers in the channel layer element.

Thus, according to preferred embodiments, the local nMOS channel layer element comprises Si_{1-z},Ge_{z}, wherein z < x.

According to preferred embodiments, z is within the range of 0 to 0.15.

According to preferred embodiments, z=0. This is currently the industrial standard, whereby the nMOS channel layer element comprises only silicon.

For a lower Germanium content in the nMOS channel layer element, relatively more silicon oxide (SiO₂) will be formed, when compared to the GeO₂ being formed. Passivation of the channel layer elements is then less difficult.

According to preferred embodiments, the local pMOS channel layer element comprises Si_{1-y},Ge_{y}, wherein y is within the range of 0.35 to 0.55. The value y can for instance be about 0.55, more preferably about 0.50, more preferably 0.45, more preferably 0.40 and more preferably 0.35.

This allows the introduction of the compressive stress as mentioned above. On top of the SiGe channel layer, a Germanium-based oxide (SiGeOₓ) is easily (naturally) formed during processing. It has been shown that the complete removal of such a sub-oxide, which is required in order to build effective and well performing devices, is very difficult with standard wet etchants, especially when the concentration of Ge in the SiGe channel layer element is around 55%, or lies for instance in the range of 53% to 57 %, or within the range of 50% to 60 %, or within the range of 45% to 65%.

Moreover, it has been shown that the strain (stress) in the SiGe channel layer element is very difficult to maintain during further processing of the FINFET processing or wafer processing (e.g. including back en of line (BEOL) processing), when the Ge content in the SiGe buffer is set up at 50 %.

It will be appreciated that SiGe layers (e.g. the SiGe pMOS channel layer element) with a Ge concentration below 55% can withstand high temperature processing, i.e. processing at temperatures above 550 °C.

According to preferred embodiments, the local nMOS channel layer element and local pMOS channel layer element are electrically separated from each other by an isolation region provided at least in the buffer layer, and preferably also at least partially in the substrate. These isolation regions can for instance correspond with shallow trench isolations (STI's), for instance comprising an oxide as for instance a silicon oxide.

According to preferred embodiments, the CMOS device further comprises a gate structure or removable gate structure on at least one of the nMOS channel layer element and the pMOS channel layer element, the removable gate structure comprising a (preferably but not necessarily common to nMOS and pMOS channel) dielectric layer, a selectively removable gate layer (RMG) and spacers or spacer structures.

The dielectric layer can for instance comprise a thin epitaxial Si layer or interfacial oxide (Si-based or Ge-based),including rare earth and transition metal elements. The spacers can for instance comprise Si02, Si nitride films or any kind of material used in the aforementioned dielectric layer.
The selectively removable gate can comprise poly silicon (polycrystalline silicon), SiO2 or a stack of silicon nitride and SiO2.

According to preferred embodiments, the CMOS device comprises elevated source and drain areas defined at respectively a first end and a second end of the respective channel layer elements, the elevated source and drain areas extending outwardly and above a respective upper surface of the nMOS channel layer elements and the pMOS channel layer elements. The elevated source and drain areas preferably also extend over the sidewalls of the channel layer elements.

These source/drain structure typically comprise a epitaxial SiGe with a Ge% properly selected to increase the channel strain (Ge% in SiGe source and drain higher than the SiGe buffer for pFETs and lower than the SiGe buffer for nFETs). In case of a Si channel for nFETs, Silicium carbide (Carbon-doped Silicon) can be preferred. For a high Ge% channel in pFETs, a GeSn source drain can be preferred.

It is an advantage that the elevated source and/or drain structures allow further controlling the stress in the respective channel layer elements. Note that the stress in the channel layers is further also determined by the buffer layer below the channel layer elements.

Moreover, the elevated source/drain structures are intrinsically (in-situ) doped. Although this may indirectly introduce dopants in the respective channel layer or substrate elements, it will be appreciated that the channel layer or substrate elements according to embodiments of the present invention does not have to be doped independently by implantation techniques. This reduces the impact of the doping process on the intrinsic performance of small transistors meaning for instance (1) better short channel effects control (strong reducion of the punch-through phenomenon by the use of elevated junctions), (2) better carrier velocity which controls the drive current I_{ON} (less coulomb scattering between carriers and dopants), and (3) improved variability parameter (dopant-induced effect). According to preferred embodiments, the elevated source and drain areas do not extend above the removable gate structure. This provides the advantage that the filling of the cavity, existing after the removal of the replacement (or removable, synonym) gate material, is not unnecessarily hampered, and can be performed in a substantially conformal manner.

According to preferred embodiments, the elevated source and drain areas or structures have a sufficient thickness (for instance within the range of 20nm to 60 nm) to allow a maximum stress transfer into the channel and to provide a low access resistance to the channel (for instance below 400 Ω.µm).

According to preferred embodiments, the removable gate structures are positioned between respective source and drain areas of the respective channel layer elements.

According to preferred embodiments, the gate structure (or removable gate structure) and elevated source/drain electrodes cover the upper surface of the respective channel layer elements completely. Preferably the sidewalls of the channel layer elements are covered completely by the (removable) gate structure and the elevated source/drain structures.

According to preferred embodiments, the local pMOS channel layer is of the short channel type, i.e. has a gate length below 30 nm.

It will furthermore be appreciated by the skilled person that embodiments according to the present invention provide the advantage of good channel passivation and reduced junction leakage. The latter is especially the case when a low Germanium concentration is used for the buffer layer, i.e. for instance a Germanium concentration below 35%, or below 30%, or below 25 %, or below 15%, or below 5%.

For pMOS FETs, embodiments according to the present invention provide the advantage that there is no need for "exotic" channel passivation, when combined with a low Germanium content in the channel.
For nMOS FETs, embodiments according to the present invention provide the advantage that there is no need for channel passivation, contrary to the case with a III-V material channel or silicon channel build-up.
Embodiments according to the present invention provide also the advantage that for low Germanium concentrations in the buffer layer, the junction leakage can be kept under control allowing for low power applications.

According to a second aspect of the present invention, a method is disclosed, the method comprising:
- providing a substrate;
- forming a buffer layer on the substrate, the buffer layer comprising Si₁₋ₓ,Geₓ;
- forming a local nMOS channel layer element of a first FET device, e.g. FINFET device, on the buffer layer, the local nMOS channel comprising Si_{1-z},Ge_{z} with z<x; and
- forming a local pMOS channel layer element of a second FET device, e.g. FINFET device, on the buffer layer, the local pMOS layer comprising Si_{1-y},Ge_{y} with y>x;
wherein x < 0.50 and wherein the nMOS channel layer element and the pMOS channel layer element extend from a surface defined by a common upper surface of the buffer layer and are part of respective (FIN)FET structures.

According to preferred embodiments, x is within the range of 0.15 to 0.45, or within the range of 0.15 to 0.35

According to preferred embodiments, the method further comprises providing a removable gate structure on at least one of the nMOS channel layer element and the pMOS channel layer element, comprising a providing a dielectric layer, providing a selectively removable gate layer and providing spacers on the respective channel layer elements.

According to preferred embodiments, the method further comprises removing the selectively removable gate layer and cleaning an upper surface of the respective channel layer elements before providing a gate layer on top of the respective channel layer element at a location corresponding to the previous location of the sacrificial gate layer.

According to preferred embodiments, the method further comprises providing, e.g. epitaxially growing, elevated source and drain structures defined at respectively a first end and a second end of the respective channels, for instance at least partially on top of said respective channels, the elevated source and drain structures extending outwardly and above a common upper surface of the nMOS channel layer element and the pMOS channel layer element.

According to preferred embodiments, the method further comprises providing elevated source and drain structures defined at respectively a first end and a second end of the respective channel layer elements, the elevated source and drain structures being grown on the buffer layer.

According to preferred embodiments, the elevated source and drain structures are provided such that they do not extend above the removable gate structure.

According to preferred embodiments, the method further comprises cleaning an upper surface of the respective channel layer elements or the SiGe buffer before providing the elevated source and drain structures.

Features and advantages as explained for embodiments of the first aspect of the present invention are applicable to the second aspect of the present invention, and vice versa, mutatis mutandis.

For the purpose of the present disclosure, whenever ranges are defined, it is intended to disclose these ranges in their closed, open, and two half open forms. All these options are meant to be disclosed even if the term "between" is used in the context of defining such ranges.

### Brief description of the drawings

The disclosure will be further elucidated by means of the following description and the appended figures.
Figure 1 illustrates an embodiment according to the present invention.
Figure 2 illustrates another embodiment according to the present invention ("integration scheme 1 ").
Figure 20 illustrates another embodiment according to the present invention. ("integration scheme 2").

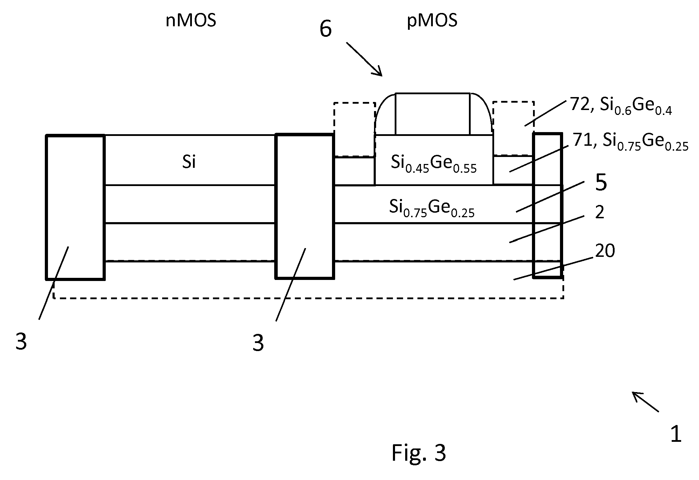

Figure 3 illustrates a further embodiment according to the present invention.

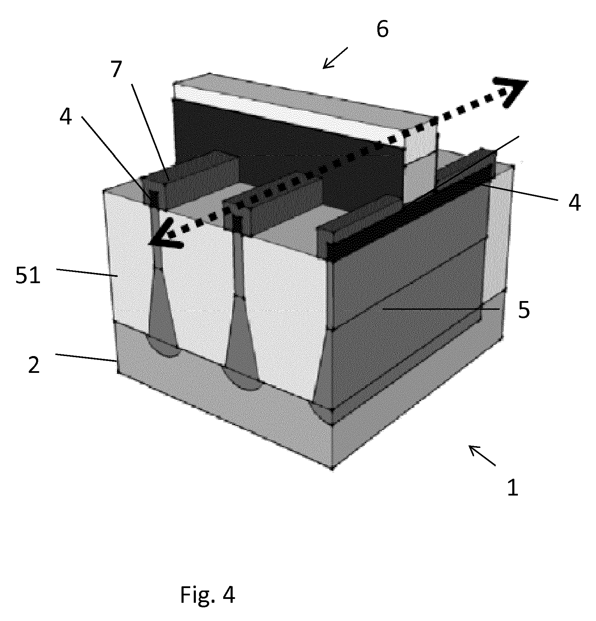

Figure 4 shows a perspective view of a FINFET structure, which provides an improved performance when constructed according to embodiments of the present invention.

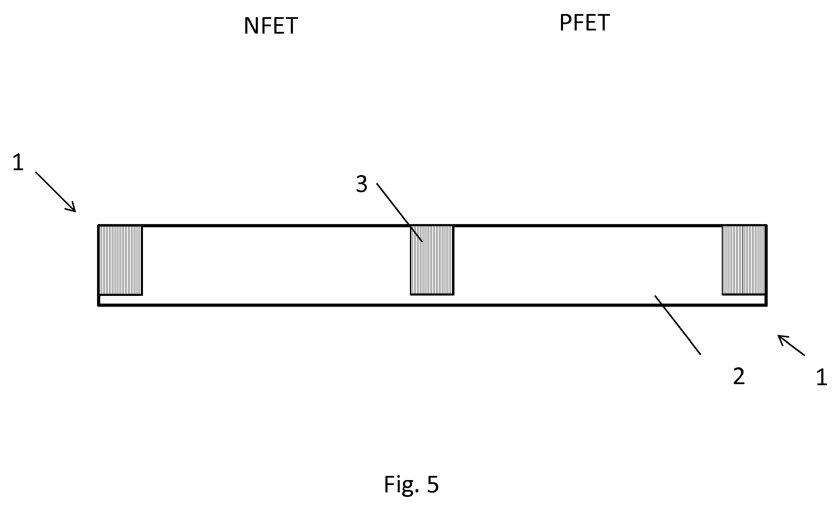

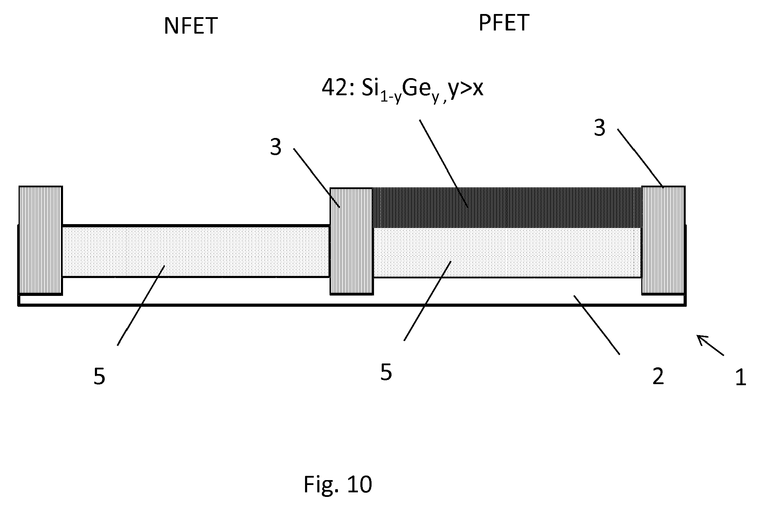

Figures 5 to 18 illustrate a process flow according to embodiments of the present invention.

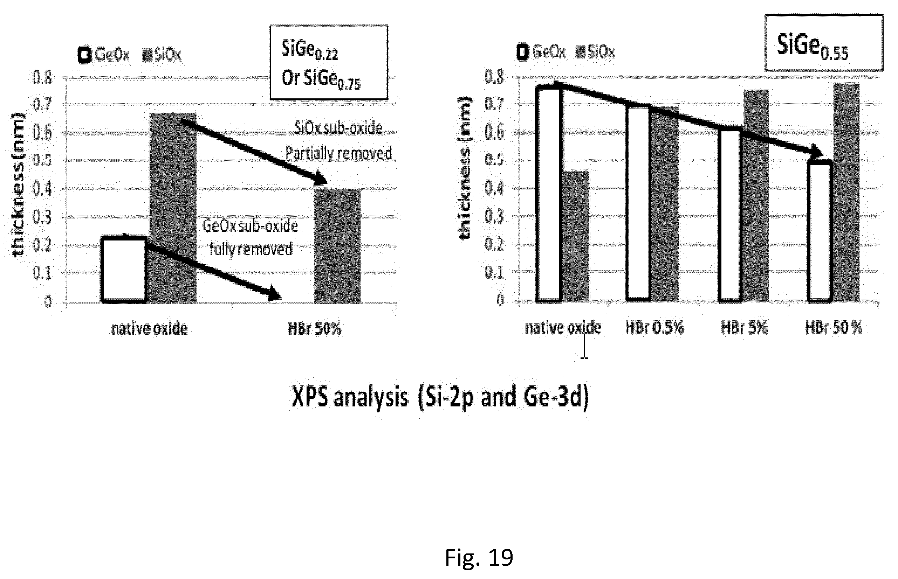

Figure 19 shows results illustrating the advantage of certain aspects of the present invention.

### Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as example manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

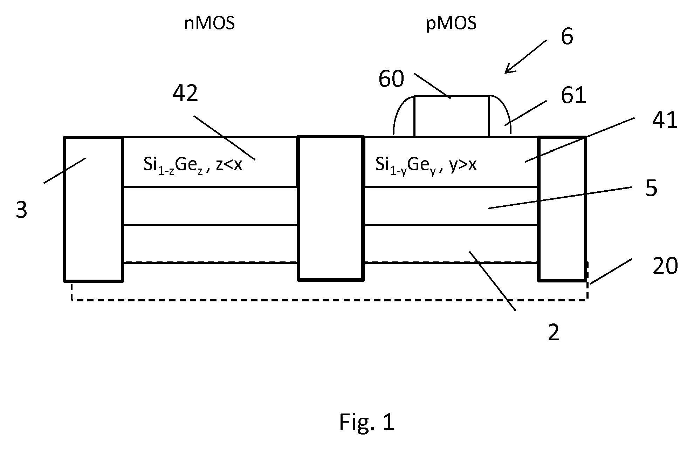

Fig. 1 illustrates a CMOS device 1 according to preferred embodiments of the present invention. On a silicon substrate 2, possibly on an oxide layer 20 (in the case of a Silicon on Insulator substrate), a buffer layer 5 comprising Si₁₋ₓGeₓ is present, whereby x is smaller than 0.5 (more preferably within 0.15 to 0.45, or within the range of 0.15 to 0.35, for instance about 0.25). nMOS channel layer elements (42) are present where nMOS devices, especially FINFET devices are to be located, and pMOS channel layer elements (41) are present where pMOS devices, especially FINFET devices are present. The nMOS and pMOS devices are electrically isolated and separated from each other by means of shallow trench isolations (STI). The nMOS channel layer element comprises Si_{1-z}Ge_{z} with z smaller than x, and comprises therefor tensile stress in a direction parallel to a main surface of the substrate 2. The pMOS channel layer element comprises Si_{1-y}Ge_{y} with y larger than x, and comprises therefor compressive stress in a direction parallel to a main surface of the substrate 2. A replacement or removable gate structure 6 (RPG) is provided on top of the pMOS channel layer element. The RPG comprises a dielectric layer, a selectively removable gate layer 60 and spacers 61.

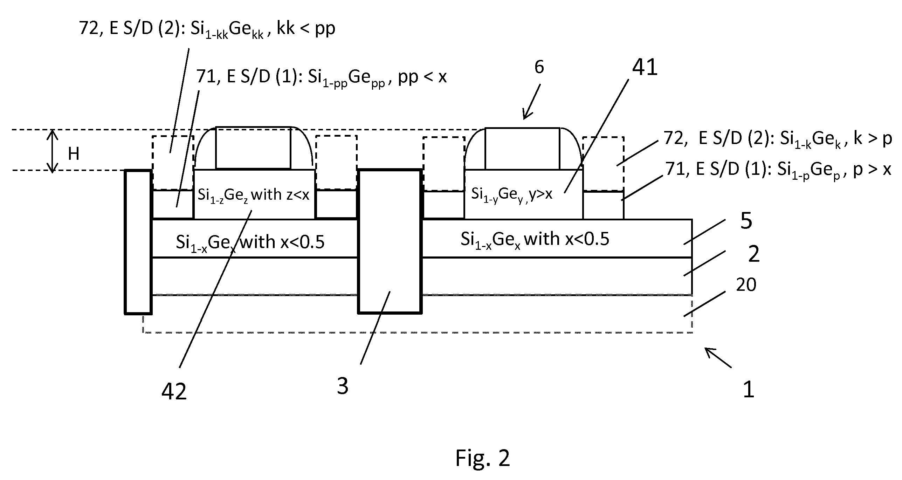

Fig. 2 illustrates another CMOS device 1 according to preferred embodiments of the present invention, according to integration scheme 1. To stress the channel and to obtain both good short channel effects control and low access resistance, elevated Source / Drain (E S/D, 7, 71, 72) electrodes are used, which are grown from the SiGe buffer. In case of Source / Drain with SiGe as a material, the Ge% content is properly set up according to the Ge% content of the relaxed SiGe buffer 5. For instance, in pFETs, higher Ge% than the one used in SiGe buffer is required to compressively strain the SiGe buffer 5 and in turn the SiGe channel 42 (SiGe channel 42 is thin enough to be lattice matched with the SiGe buffer 5). Similar approach can be integrated in nFETs comprising the use of low Ge% in SiGe S/D 7, 71, 72 with respect to the SiGe buffer 5. This concept can be extended to other materials like Si:C for elevated source/drain in NFETs (tensile strain) or like GeSn S/D pFETs.

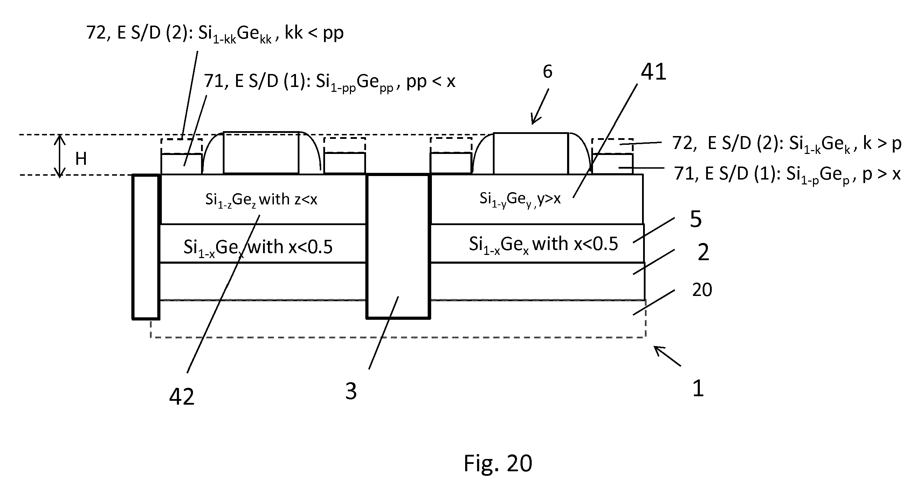

In Fig. 20, another integration scheme (scheme 2) is provided wherein the growth of elevated source and drain is performed from the SiGe channel layer itself (as opposed to the integration scheme 1 given in Fig.2 where source and drain are grown from the SiGe buffer). For cleaning purpose, this scheme is preferably limited to a Ge concentration inside the channel layer being below 50%. An advantage of providing the elevated electrodes as in scheme 2 is the stress enhancement at the channel level, when compared to the case of scheme 1, because the strain relaxation after etching out the SiGe channel layer is then limited (the channel layer is not free-standing). This is therefor a preferred integration scheme for highly-scaled pFETs (for instance having a gate length below 30nm). A similar concept is applicable to nFETs.

In Fig. 3 a further preferred embodiment is illustrated, based on the embodiment of Fig. 2, but wherein the nMOS channel layer element 41 consists of a silicon layer element. The buffer layer 5 comprises Si_{0.75}Ge_{0.25}. The pMOS channel layer comprises Si_{0.55}Ge_{0.45}. The elevated source and drain structures can be graded layers wherein the Germinium concentration increases when going upwards, away from the buffer layer. The elevated source/drain structures can for instance comprise areas or layers 71 and 72 comprising Si_{0.75}Ge_{0.25} and Si_{0.55}Ge_{0.45} respectively. For instance, a bottom layer, e.g. layer 71 can have a germanium concentration in the range between the germanium concentration of the buffer up to a germanium concentration of 25%. An upper layer, e.g. layer 72, can have a concentration of germanium which increases upwards away from the layer 71, between the concentration of the (upper part of the) layer 71 and 55%. A graded germanium layer can for instance have a germanium concentration in the range between the germanium concentration of the buffer up to a germanium concentration of 55%, when going from the channel layer or buffer layer upwards up to the front surface of the elevated source/drain structures.

Some advantages of this integration scheme are:
- the use of Si channel for nFETs which is an industry standard;
- the lattice match between the channel and the SiGe buffer for both pFETs and nFETs is voluntarily limited in order to be able to keep up the proper strain at high level even after full processing;
- the use of Si_{0.55}Ge_{0.45} channel for pFETs is potentially compatible with known cleaning procedures and ultimately do not require exotic surface passivation (Si-free passivation cap enabler);
- the Ge% in Source / Drain 7, 71, 72 is set up on purpose to maximize the stress transfer into the channel 41, 42 via the SiGe buffer 5 and to minimize the access resistance. A dual layer 71, 72 in elevated SiGe Source / Drain is shown in Fig. 3, which enables the integration of thick and strained Si_{0.55}Ge_{0.45} layer.

In Fig. 4 a CMOS FET device 1 is depicted according to embodiments of the first aspect of the present invention, which can be manufactured by any of the methods according to the second aspect of the present invention. The dotted line defines a direction perpendicular on the views depicted in Fig. 1 to Fig. 3 and in Fig. 5 to Fig. 18. A substrate 2 comprises a buffer layer, or different buffer layer elements 5 (three in number), the buffer layer elements having a longitudinal direction, and being parallel to each other. The buffer layer elements are being separated from each other by for instance an oxide 51. The buffer layers are abutting on respective channel layer elements (41, 42), typically all of the same type, for instance the p-type. The channel layer elements constitute FIN structure of a multiple FINs FINFET structure (3D-gate). On top of the channel layer elements a replacement gate structure 6 is provided, with a longitudinal direction essentially perpendicular on the longitudinal direction of the channel layer element. The channel layer elements 42 are further provided with elevated source / drain structures 7, which cover the still remaining uncovered part of the channel layer elements 42.

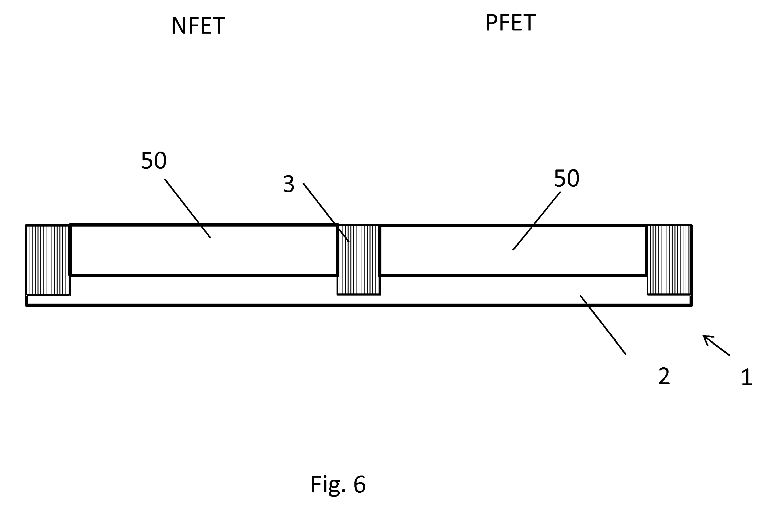

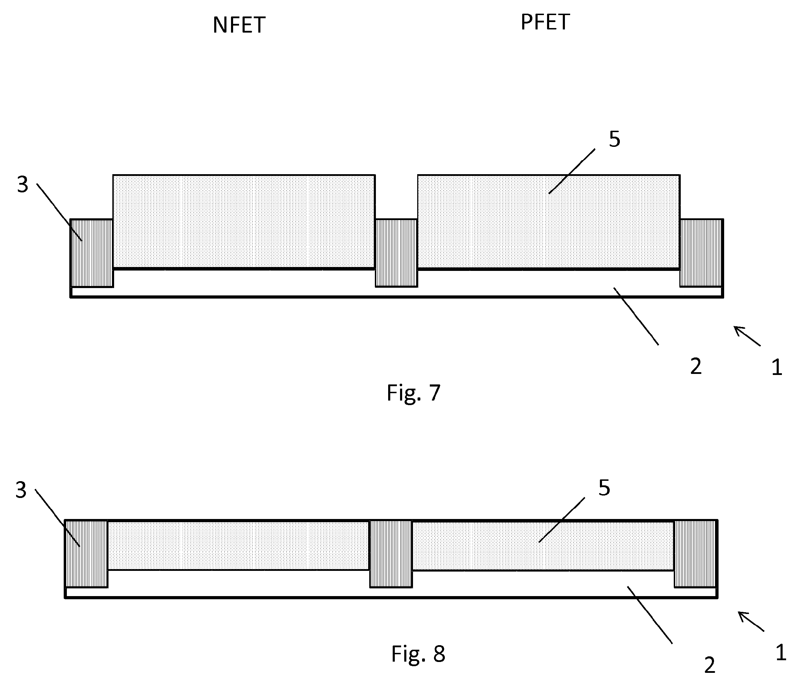

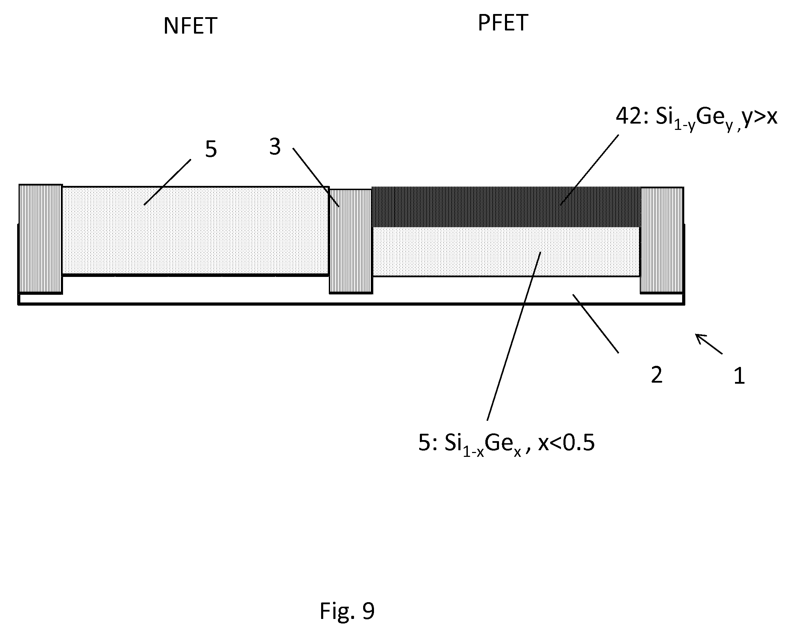

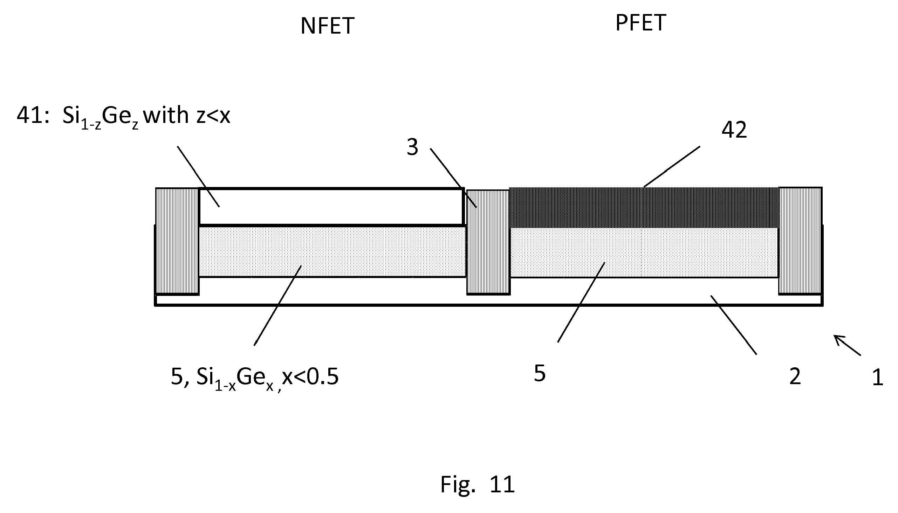

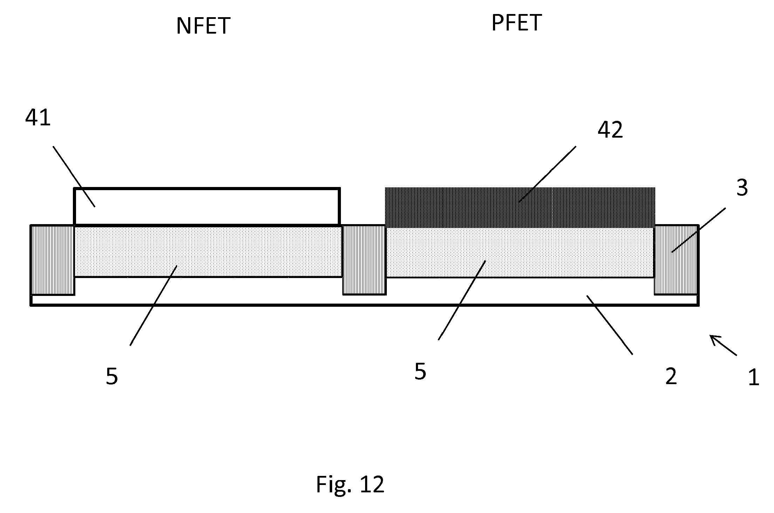

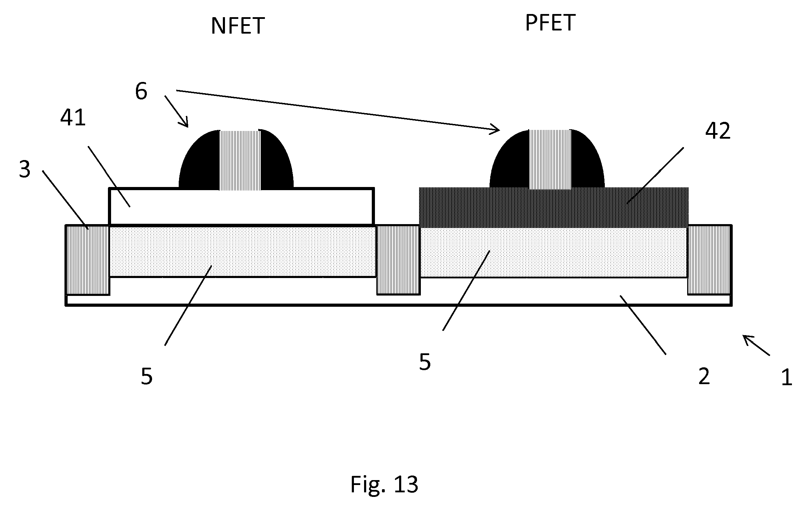

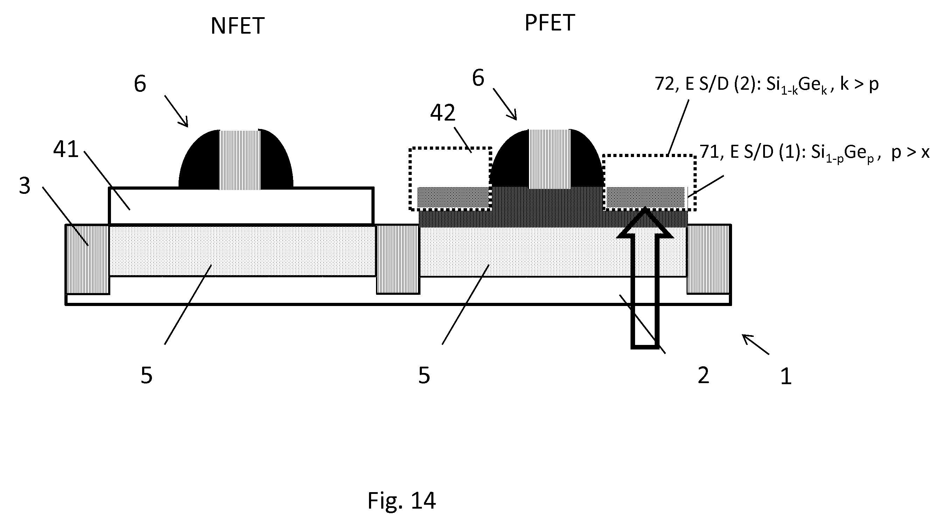

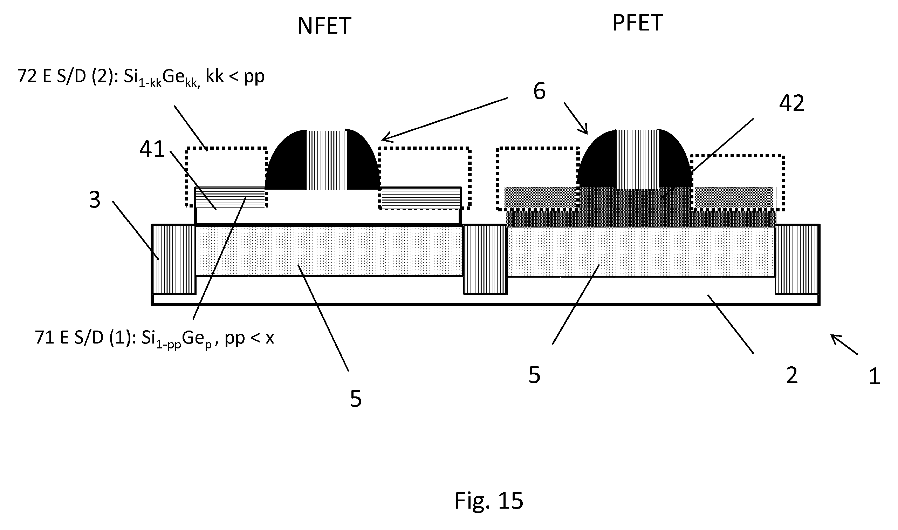

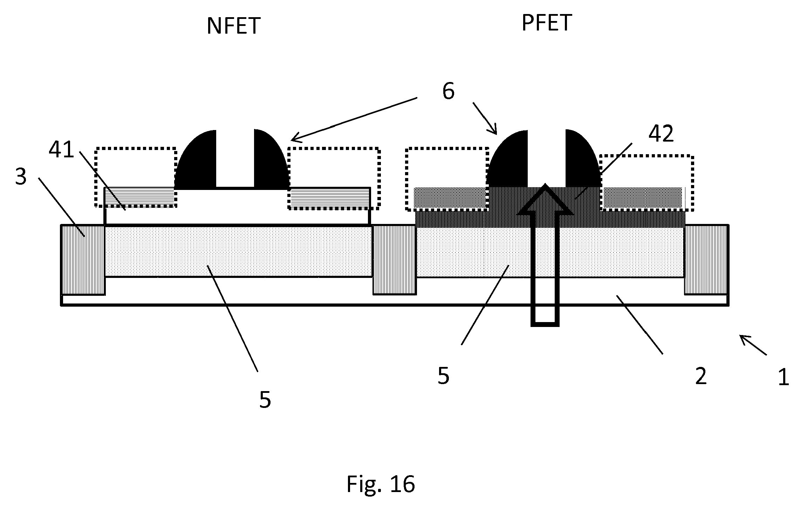

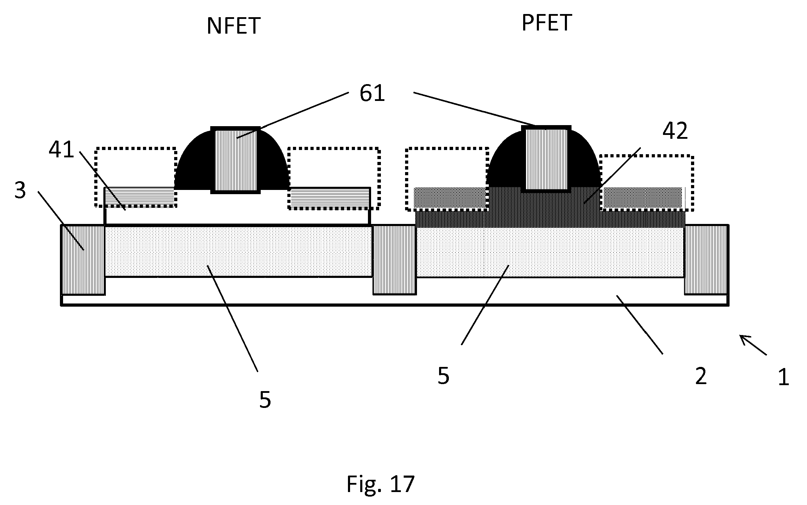

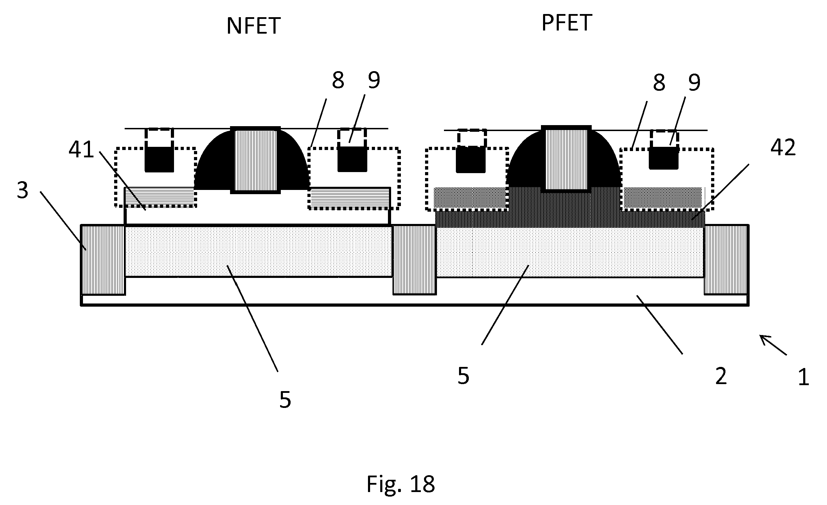

In Figures 5 to 18, a process flow according to embodiments of the present invention is depicted. In figure 5, standard Si-in-STI wafer (2,3) are used. Alternative substrates as for instance SiGe-bulk, SOI or strained-SOl substrates can be employed. The isolation material for the trenches, e.g. SiO2 in the STI module is classically provided in multiple steps: for instance, a high thermal oxide can be grown on a silicon substrate 2 provided with shallow trenches, and then a low thermal plasma oxide 3 is deposited thereon filling the trenches. Finally a CMP step can be carried out to fully planarize the wafer. Fig. 6 shows the step of providing silicon recesses 50 between STI trenches to enable the epitaxial growth of the SiGe buffer 5 (Fig.7). Fig.8 depicts both pFET and nFET parts after a CMP step on the grown buffer layer 5. Hereby substantially flat SiGe surfaces are then obtained. Subsequently, as illustrated in Fig.9, the nFET component is masked (usually by a thick oxide), and the pFET channel 42 can be designed: SiGe buffer 5 is first recessed and higher Ge% SiGe-channel 42 is epitaxially grown. After opening up the nFET area and covering the pFET area, a similar operation is performed resulting in the growth of the nFET channel 41 (Fig.11). In the preferred option, a thin Silicon 41 layer is epitaxially grown. In Figure 12, the FIN embodying a channel in a FINFET architecture (called also 3D-gate) is created by recessing the STI 3. Gate stack and spacers regions are integrated on top of the FIN (Fig.13). Using similar procedures as defined in the channel 4, 41, 42 formation (mask and strip), elevated source and drain are grown in the dedicated regions (on top of SiGe-channel, on top of SiGe-buffer). For the reasons aforementioned (high strain and low access resistance), the channel material in the source / drain area can be etched away (partially or fully removed). Fig.14 illustrates the pFET component and Fig.15 the nFET component. Fig.16 illustrated the dummy gate removal in case of the use of a replacement gate scheme. Fig.17 illustrates the step showing the deposition of the final gate dielectric and the metal having appropriate work function to set up the type of application targeted (Ultra low Standby power, Low Power or High performance). Classical back-end-of-line operations are finally illustrated in Fig.18, comprising providing a dielectric layer 8 and providing contacts to the elevated S/D regions through the dielectric layer.

Fig. 19 provides experimental results illustrating certain advantages according to aspects of the present disclosure.
In the graph on the right hand side, results are illustrated showing the thickness of GeOx and SiOx layers after different typical oxide removal processes, for a SiGe layer comprising Si₄₅Ge₅₅. In the graph on the left hand side, the same results are illustrated for an oxide removal process based on HBr 50%, on top of a SiGe layer with a Ge concentration which is substantially higher or lower than 55% (Si₇₈Ge_{0.22} and Si_{0.25}Ge_{0.75}) The right graph shows that SiOx and GeOx are difficult to remove in case of a SiGe surface with a Ge concentration around 55%. To the contrary, a Si₇₈Ge_{0.22} (or Si₇₅Ge_{0.25}) or Si_{0.25}Ge_{0.75} surface can be more easily cleaned: sub-oxide GeOx is, in this example, fully removed by a 50% HBr - based recipe whereas the classical SiOx can be removed by conventional chemistries like with HF-based or TMAH-based solutions. This result particularly defines the Ge% concentration of the SiGe channel layer element inside the SiGe pFET channel. In case of the use of Ge% around 50% in the SiGe pFET channel 42, there is a high risk that the elevated SiGe Source/Drain 7, 71, 72 is not growing or that after dummy gate stack removal, contaminants remain on top of the channel layer element 42 and cannot be removed when depositing the final gate stack.

## Claims

1. A CMOS device (1) comprising silicon and germanium, a substrate, (2) a buffer layer (5) on said substrate, (2) said buffer layer (5) comprising Si₁₋ₓ,Geₓ a local nMOS channel layer element (42) of a first FINFET device on said buffer layer (5) (Si_{1-z},Ge_{z} with z<x), and
a local pMOS channel layer element (41) of a second FINFET device on said buffer layer (5) (Si_{1-y},Ge_{y} with y>x);
wherein with x < 0.50 and wherein said nMOS channel layer element (42) and said pMOS channel layer element (41) extend from a surface defined by a common upper surface of said buffer layer (5) and are part of respective FINFET structures,
wherein x is within the range of 0.15 to 0.45;
wherein z is within the range between 0 and 0.15; and
**characterized in that** said local pMOS channel layer element (41) comprises Si_{1-y},Ge_{y}, wherein y is within the range of 0.35 to 0.55.

2. A CMOS device according to claim 1, wherein said local nMOS channel layer element and local pMOS channel layer element are electrically separated from each other by an isolation region provided at least in said buffer layer.

3. A CMOS device according to any of the previous claims, further comprising a removable gate structure on at least one of said nMOS channel layer element and said pMOS channel layer element, said removable gate structure comprising a dielectric layer, a selectively removable gate layer and spacers.

4. A CMOS device according to any of the previous claims, further comprising elevated source and drain areas defined at respectively a first end and a second end of said respective channel layer elements, said elevated source and drain areas extending outwardly and above a common upper surface of said nMOS channel layer elements and said pMOS channel layer elements.

5. A CMOS device according to claim 4, wherein said elevated source and drain areas do not extend above said removable gate structure.

6. A method for manufacturing the device (1) of any of the claims 1 to 5, the method comprising
- providing a substrate; (2) forming a buffer layer (5) on said substrate, (2) said buffer layer (5) comprising Si₁₋ₓ,Geₓ;
- forming a local nMOS channel layer element (42) of a first FINFET device on said buffer layer, (5) said local nMOS channel layer element (42) comprising Si_{1-z},Ge_{z} with z<x; and
- forming a local pMOS channel layer element (41) of a second FINFET device on said buffer layer, (5) said local pMOS channel layer element (41) comprising Si_{1-y},Ge_{y} with y>x;
- wherein x < 0.50 and wherein said nMOS channel layer element (42) and said pMOS channel layer element (41) extend from a surface defined by a common upper surface of said buffer layer (5) and are part of respective FINFET structures; wherein x is within the range of 0.15 to 0.45; , wherein z is within the range between 0 and 0.15; and **characterized in that** y is within the range of 0.35 to 0.55.

7. A method according to claim 6, further comprising providing a removable gate structure on at least one of said nMOS channel layer element and said pMOS channel layer element, comprising a providing a dielectric layer, providing a selectively removable gate layer and providing spacers on said respective channel layer elements.

8. A method according to claim 7, further comprising removing said selectively removable gate layer and cleaning an upper surface of said respective channel layer elements before providing a gate layer on top of said respective channel layer element at a location corresponding to the previous location of the sacrificial gate layer.

9. A method according to any of claims 6 to 8, further comprising providing elevated source and drain structures defined at respectively a first end and a second end of said respective channel layer elements, said elevated source and drain structures extending outwardly and above a common upper surface of said nMOS channel layer element and said pMOS channel layer element.

10. The method according to any of claims 6 to 8, further comprising providing elevated source and drain structures defined at respectively a first end and a second end of the respective channel layer elements, the elevated source and drain structures being grown on said buffer layer.

11. A method according to claims 9 or 10, further comprising cleaning an upper surface of said respective channel layer elements before providing said elevated source and drain structures, or comprising cleaning an upper surface of said buffer layer before providing said elevated source and drain structures.

## Patentansprüche

1. CMOS Vorrichtung (1), umfassend Silizium und Germanium,
ein Substrat (2),
eine Pufferschicht (5) auf dem Substrat (2), wobei die Pufferschicht (5) Si₁₋ₓ,Geₓ umfasst,
ein lokales nMOS-Kanalschichtelement (42) einer ersten FINFET-Vorrichtung auf der Pufferschicht (5) (Si_{1-z},Ge_{z} mit z<x), und
ein lokales pMOS-Kanalschichtelement (41) einer zweiten FINFET-Vorrichtung auf der Pufferschicht (5) (Si_{1-y},Ge_{y} mit y>x);
wobei mit x < 0,50 und wobei das nMOS-Kanalschichtelement (42) und das pMOS-Kanalschichtelement (41) sich von einer Fläche aus erstrecken, welche durch eine gemeinsame Oberfläche der Pufferschicht (5) definiert ist, und Teil jeweiliger FINFET-Strukturen sind,
wobei x innerhalb des Bereichs von 0,15 bis 0,45 ist;
wobei z innerhalb des Bereichs zwischen 0 und 0,15 ist; und
**dadurch gekennzeichnet, dass**
das lokale pMOS-Kanalschichtelement (41) Si_{1-y},Ge_{y} umfasst, wobei y innerhalb des Bereichs von 0,35 bis 0,55 ist.

2. CMOS Vorrichtung nach Anspruch 1, wobei das lokale nMOS-Kanalschichtelement und lokale pMOS-Kanalschichtelement durch einen Isolationsabschnitt elektrisch voneinander getrennt sind, welcher zumindest in der Pufferschicht bereitgestellt ist.

3. CMOS Vorrichtung nach einem der vorangehenden Ansprüche, des Weiteren umfassend eine entfernbare Gate-Struktur auf zumindest einem des nMOS-Kanalschichtelements und des pMOS-Kanalschichtelements, wobei die entfernbare Gate-Struktur eine dielektrische Schicht, eine wahlweise entfernbare Gate-Schicht und Abstandhalter umfasst.

4. CMOS Vorrichtung nach einem der vorangehenden Ansprüche, des Weiteren umfassend angehobene Source- und Drain-Areale, welche an einem ersten Ende bzw. einem zweiten Ende der jeweiligen Kanalschichtelemente definiert sind, wobei sich die angehobenen Source- und Drain-Areale nach außen und über einer gemeinsamen Oberfläche der nMOS-Kanalschichtelemente und der pMOS-Kanalschichtelemente erstrecken.

5. CMOS Vorrichtung nach Anspruch 4, wobei sich die angehobenen Source- und Drain-Areale nicht über die entfernbare Gate-Struktur erstrecken.

6. Verfahren zum Herstellen der Vorrichtung (1) nach einem der Ansprüche 1 bis 5, wobei das Verfahren umfasst:
- Bereitstellen eines Substrats (2);
- Bilden einer Pufferschicht (5) auf dem Substrat (2), wobei die Pufferschicht (5) Si₁₋ₓ,Geₓ umfasst;
- Bilden eines lokalen Kanalschichtelements (42) einer ersten FINFET-Vorrichtung auf der Pufferschicht (5), wobei das lokale nMOS-Kanalschichtelement (42) Si_{i-z},Ge_{z} mit z<x umfasst; und
- Bilden eines lokalen pMOS-Kanalschichtelements (41) einer zweiten FINFET-Vorrichtung auf der Pufferschicht (5), wobei das lokale pMOS-Kanalschichtelement (41) Si_{1-y},Ge_{y} mit y>x umfasst;
- wobei x < 0,50 ist und wobei sich das nMOS-Kanalschichtelement (42) und das pMOS-Kanalschichtelement (41) von einer Fläche aus erstrecken, welche durch eine gemeinsame Oberfläche der Pufferschicht (5) definiert ist, und Teil jeweiliger FINFET-Strukturen sind;
wobei x innerhalb des Bereichs von 0,15 bis 0,45 ist;
wobei z innerhalb des Bereichs zwischen 0 und 0,15 ist; und
**dadurch gekennzeichnet, dass** y innerhalb des Bereichs von 0,35 bis 0,55 ist.

7. Verfahren nach Anspruch 6, des Weiteren umfassend ein Bereitstellen einer entfernbaren Gate-Struktur auf zumindest einem des nMOS-Kanalschichtelements und des pMOS-Kanalschichtelements, umfassend ein Bereitstellen einer dielektrischen Schicht, Bereitstellen einer wahlweise entfernbaren Gate-Schicht und Bereitstellen von Abstandhaltern auf den jeweiligen Kanalschichtelementen.

8. Verfahren nach Anspruch 7, des Weiteren umfassend ein Entfernen der wahlweise entfernbaren Gate-Schicht und Reinigen einer Oberfläche der jeweiligen Kanalschichtelemente vor Bereitstellen einer Gate-Schicht auf der Oberseite des jeweiligen Kanalschichtelements an einer Stelle, die der vorherigen Stelle der Gate- Opferschicht entspricht.

9. Verfahren nach einem der Ansprüche 6 bis 8, des Weiteren umfassend ein Bereitstellen angehobener Source- und Drain-Strukturen, welche an einem ersten Ende bzw. einem zweiten Ende der jeweiligen Kanalschichtelemente definiert sind, wobei sich die angehobenen Source- und Drain-Strukturen nach außen und über eine gemeinsame Oberfläche des nMOS-Kanalschichtelements und des pMOS-Kanalschichtelements erstrecken.

10. Verfahren nach einem der Ansprüche 6 bis 8, des Weiteren umfassend ein Bereitstellen angehobener Source- und Drain-Strukturen, welche an einem ersten Ende bzw. einem zweiten Ende der jeweiligen Kanalschichtelemente definiert sind, wobei die angehobenen Source- und Drain-Strukturen auf der Pufferschicht angebaut sind.

11. Verfahren nach Anspruch 9 oder 10, des Weiteren umfassend ein Reinigen einer oberen Oberfläche der jeweiligen Kanalschichtelemente vor Bereitstellen der angehobenen Source- und Drain-Strukturen oder umfassend ein Reinigen einer oberen Oberfläche der Pufferschicht vor Bereitstellen der angehobenen Source- und Drain-Strukturen.

## Revendications

1. Dispositif CMOS (1) comprenant du silicium et du germanium, un substrat (2), une couche tampon (5) sur ledit substrat (2), ladite couche tampon (5) comprenant du Si₁₋ₓ,Geₓ
un élément de couche de canal nMOS local (42) d'un premier dispositif FINFET sur ladite couche tampon (5) (Si_{1-z},Ge_{z} avec z < x), et
un élément de couche de canal pMOS local (41) d'un second dispositif FINFET sur ladite couche tampon (5) (Si_{1-y},Ge_{y} avec y > x) ;
dans lequel avec x < 0,50 et dans lequel ledit élément de couche de canal nMOS (42) et ledit élément de couche de canal pMOS (41) s'étendent à partir d'une surface définie par une surface supérieure commune de ladite couche tampon (5) et font partie de structures FINFET respectives, dans lequel x est dans la plage de 0,15 à 0,45 ; dans lequel z est dans la plage entre 0 et 0,15 ; et
**caractérisé en ce que** ledit élément de couche de canal pMOS local (41) comprend du Si_{1-y},Ge_{y}, dans lequel y est dans la plage de 0,35 à 0,55.

2. Dispositif CMOS selon la revendication 1, dans lequel lesdits élément de couche de canal nMOS local et élément de couche de canal pMOS local sont électriquement séparés l'un de l'autre par une région isolante prévue au moins dans ladite couche tampon.

3. Dispositif CMOS selon l'une quelconque des revendications précédentes, comprenant en outre une structure de grille amovible sur au moins un dudit élément de couche de canal nMOS et dudit élément de couche de canal pMOS, ladite structure de grille amovible comprenant une couche diélectrique, une couche de grille amovible de manière sélective et des entretoises.

4. Dispositif CMOS selon l'une quelconque des revendications précédentes, comprenant en outre des zones de source et de drain élevées respectivement définies au niveau d'une première extrémité et d'une seconde extrémité desdits éléments de couche de canal respectifs, lesdites zones de source et de drain élevées s'étendant vers l'extérieur et au-dessus d'une surface supérieure commune desdits éléments de couche de canal nMOS et desdits éléments de couche de canal pMOS.

5. Dispositif CMOS selon la revendication 4, dans lequel lesdites zones de source et de drain élevées ne s'étendent pas au-dessus de ladite structure de grille amovible.

6. Procédé pour fabriquer le dispositif (1) selon l'une quelconque des revendications 1 à 5, le procédé comprenant
- la fourniture d'un substrat (2) ;
- la formation d'une couche tampon (5) sur ledit substrat (2), ladite couche tampon (5) comprenant du Si,__{X},Ge_{X} ;
- la formation d'un élément de couche de canal nMOS local (42) d'un premier dispositif FINFET sur ladite couche tampon (5), ledit élément de couche de canal nMOS local (42) comprenant du Si_{1-z},Ge_{z} avec z < x ; et
- la formation d'un élément de couche de canal pMOS local (41) d'un second dispositif FINFET sur ladite couche tampon (5), ledit élément de couche de canal pMOS local (41) comprenant du Si_{1-y},Ge_{y} avec y > x ;
- dans lequel x < 0,50 et dans lequel ledit élément de couche de canal nMOS (42) et ledit élément de couche de canal pMOS (41) s'étendent à partir d'une surface définie par une surface supérieure commune de ladite couche tampon (5) et font partie de structures FINFET respectives ; dans lequel x est dans la plage de 0,15 à 0,45 ; dans lequel z est dans la plage entre 0 et 0,15 ; et
**caractérisé en ce que** y est dans la plage de 0,35 à 0,55.

7. Procédé selon la revendication 6, comprenant en outre la fourniture d'une structure de grille amovible sur au moins un dudit élément de couche de canal nMOS et dudit élément de couche de canal pMOS, comprenant la fourniture d'une couche diélectrique, la fourniture d'une couche de grille amovible de manière sélective et la fourniture d'entretoises sur lesdits éléments de couche de canal respectifs.

8. Procédé selon la revendication 7, comprenant en outre l'enlèvement de ladite couche de grille amovible de manière sélective et le nettoyage d'une surface supérieure desdits éléments de couche de canal respectifs avant la fourniture d'une couche de grille sur le dessus dudit élément de couche de canal respectif à un emplacement correspondant à l'emplacement précédent de la couche de grille sacrificielle.

9. Procédé selon l'une quelconque des revendications 6 à 8, comprenant en outre la fourniture de structures de source et de drain élevées définies respectivement au niveau d'une première extrémité et d'une seconde extrémité desdits éléments de couche de canal respectifs, lesdites structures de source et de drain élevées s'étendant vers l'extérieur et au-dessus d'une surface supérieure commune dudit élément de couche de canal nMOS et dudit élément de couche de canal pMOS.

10. Procédé selon l'une quelconque des revendications 6 à 8, comprenant en outre la fourniture des structures de source et de drain élevées définies respectivement au niveau d'une première extrémité et d'une seconde extrémité des éléments de couche de canal respectifs, les structures de source et de drain élevées étant cultivées sur ladite couche tampon.

11. Procédé selon les revendications 9 ou 10, comprenant en outre le nettoyage d'une surface supérieure desdits éléments de couche de canal respectifs avant la fourniture desdites structures de source et de drain élevées, ou comprenant le nettoyage d'une surface supérieure de ladite couche tampon avant la fourniture desdites structures de source et de drain élevées.
